# EUROPEAN PATENT APPLICATION

(11) **EP 0 552 542 A1**
(43) Date of publication of application: **28.07.1993**
(21) Application number: 92310833.6
(22) Date of filing: 26.11.1992
(51) Int. Cl.: G01R 33/38

(54) **Multiple independent mobile imaging gradient coil transport system**

(30) Priority: 27.11.1991 US 797830
(71) Applicant: OTSUKA ELECTRONICS, Fort Collins, Colorado 80525 (US)
(72) Inventor: Heinzelman, Bert D., Tenafly, New Jersey 07670 (US); Brooks, Christopher J., Glen Head, New York 11545 (US)
(74) Representative: Jones, Alan John

(57) **Abstract**

The present invention provides a mechanism for allowing multiple configurations of imaging gradient coils to be utilized within an MRI system. The present invention provides a transport cart that is constructed to allow multiple configurations of imaging gradient coils to be easily inserted and removed from an MRI system. The present invention provides a less costly mechanism of producing superior images without the necessity of owning multiple machines.

## Description

### BACKGROUND OF THE INVENTION

### 1. Field of the Invention

The present invention relates generally to the field of magnetic resonance imaging (MRI), and more particularly to an apparatus for allowing multiple configurations of imaging gradient coils to be integrated into a MRI system.

### 2. Discussion of Related Art

Presently, magnetic resonance imaging (MRI) systems are constructed with permanent imaging gradient coils. Gradient coils and the MRI sytems that utilize them are well known in the art. Typically, a whole body gradient coil would be permanently mounted within the MRI device in order to produce an image of the human body. Whole body gradient coils are expensive and less effective then application specific coils, such as head or spine gradient coils, which are specific to a particular part or region of the human body. Performance of gradient coils is dependent upon the gradient strength of the particular gradient coil being utilized. The performance of whole body gradient coils suffers because of the its internal gradient strength. In addition, whole body gradient coils are very expensive.

In order to improve the image quality for specific parts of the body above that produced by whole body gradient coils, as well as decrease the cost of the entire MRI system, application specific gradient coils (e.g., head or spine coils) have been permanently affixed inside the MRI system. The application specific coils produce a superior image for the particular part of region of the human body because of their increased gradient strength.

However, certain types of widely used gradient coils cannot co-exist in the same MRI system. For example, a head gradient coil designed to produce superior head images cannot co-exits with a gradient coil designed to produce superior spine images within the same MRI system. Thus, a user of a MRI system would need to purchase multiple MRI systems in order to utilize both types of application speciific gradient coils. Having to purchase multiple MRI systems is both cost and space restrictive.

Consequently, an MRI system is needed that provides a means of producing exceptional image quality, while allowing multiple, sometimes conflicting, gradient coils to be utilized in the same MRI system.

### SUMMARY OF THE INVENTION

In view of the foregoing, the present invention provides a mechanism for allowing multiple, possibly conflicting configurations of imaging gradient coils to be implemented within a single MRI system. The present invention provides a transport cart that is constructed to allow multiple configurations of imaging gradient coils to be easily installed and removed from an MRI system. The present invention provides a less costly mechanism of producing superior images without the necessity of owning multiple machines.

The gradient transport cart includes a main frame, a plurality of rotatable transport wheels connected to the frame, a gradient collar connected to the frame, a gradient coil tube for housing an application specific gradient coil, the gradient coil tube connected to the gradient collar, and attachment means for attaching the gradient coil tube to the gradient collar. Moreover, the present invention provides a means of securely fastening the gradient transport cart 100 to the MRI system.

### BRIEF DESCRIPTION OF THE DRAWINGS

The foregoing and other features and advantages of the invention will be apparent from the following more particular description of the preferred embodiments of the invention, as illustrated in the accompanying drawing, in which:
FIG. 1(a) shows a side view of a preferred embodiment of a gradient transport cart 100 of the present invention;
FIG. 1(b) shows a rear view of the gradient transport cart 100 of the present invention;
FIG. 1(c) shows a front view of the gradient tube 135 of the present invention;
FIG. 2(a) shows a side view of a representative MRI system 200 that incorporates the gradient transport cart 100 of the present invention;
FIG. 2(b) shows a front view of the MRI system 200 of the present invention;
FIG. 2(c) shows a rear view of the MRI system 200 of the present invention with the gradient transport cart 100 in place; and
FIG. 2(d) shows a rear view of the MRI system 200 of the present invention with the gradient transport cart 100 removed.

### DETAILED DESCRIPTION OF THE PREFERRED EMBODIMENTS

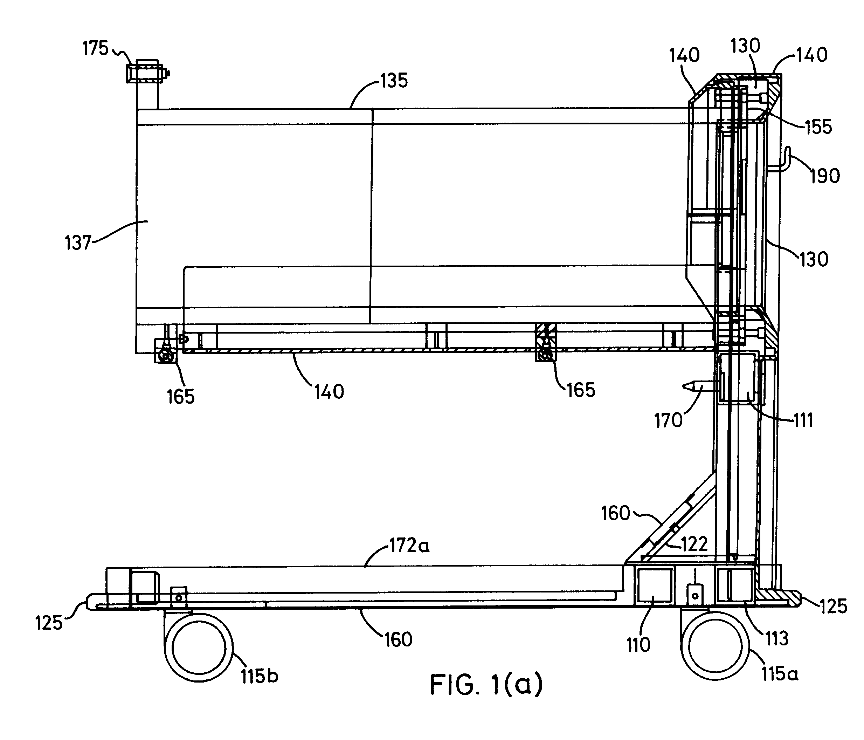

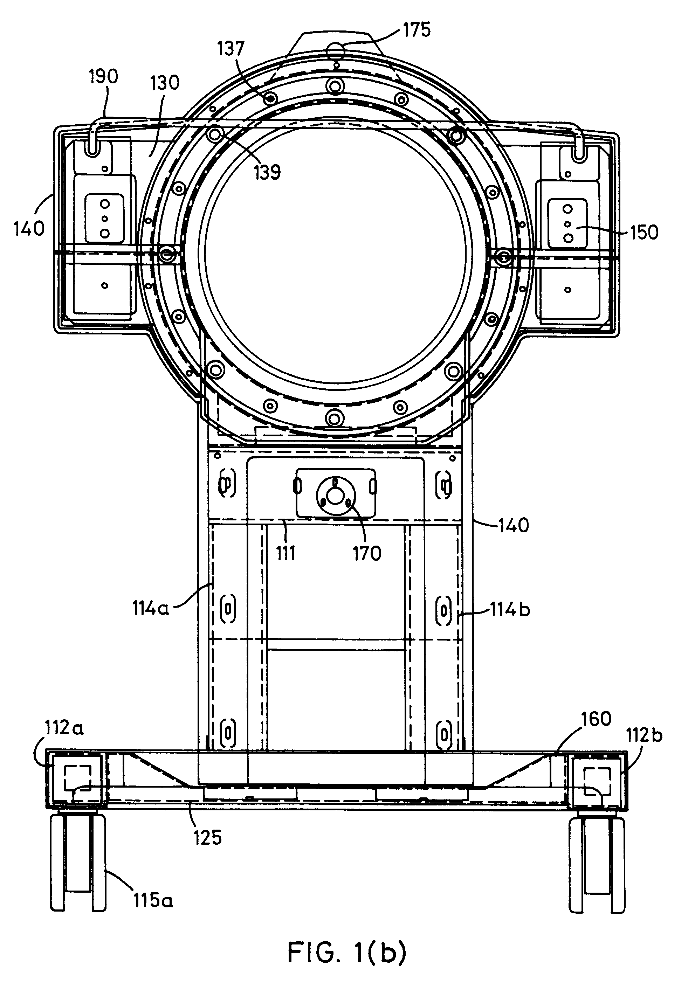

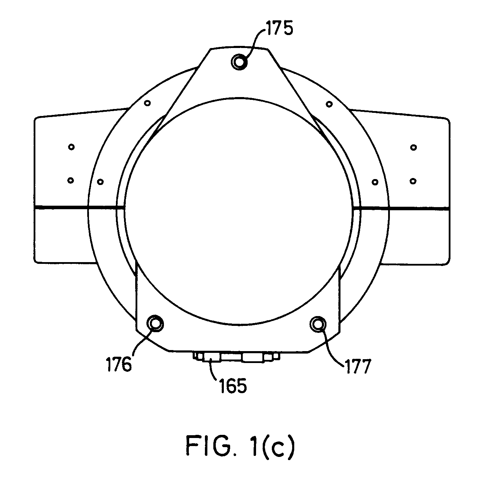

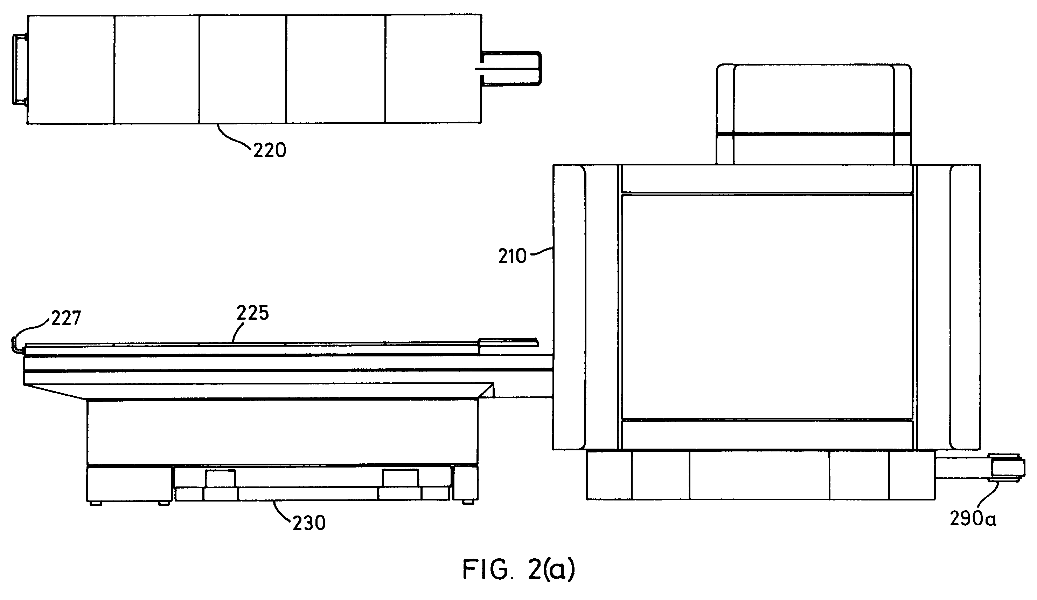

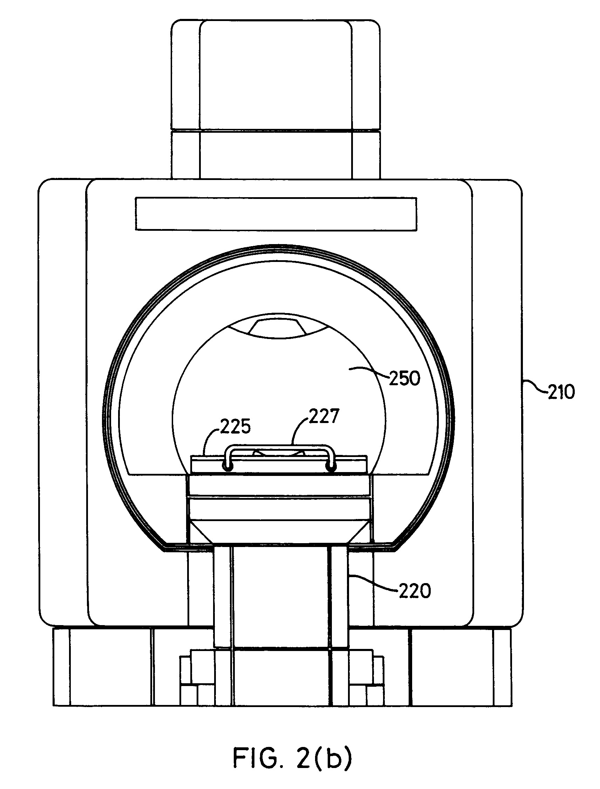

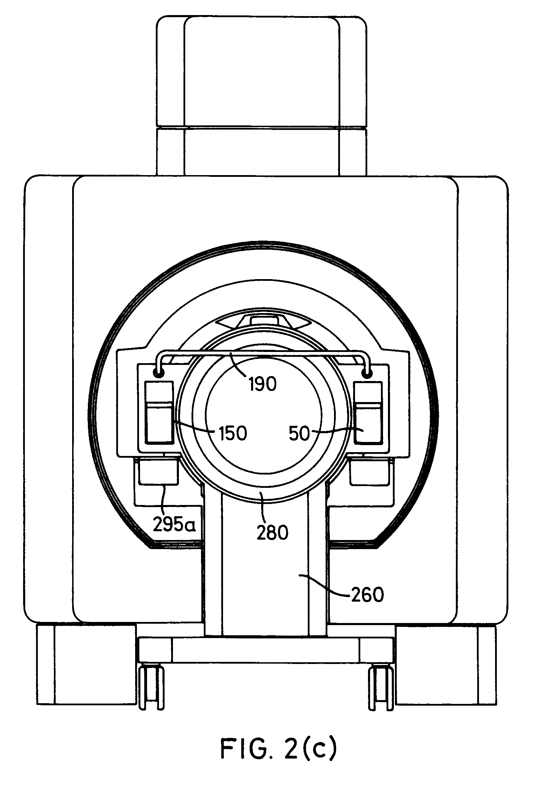

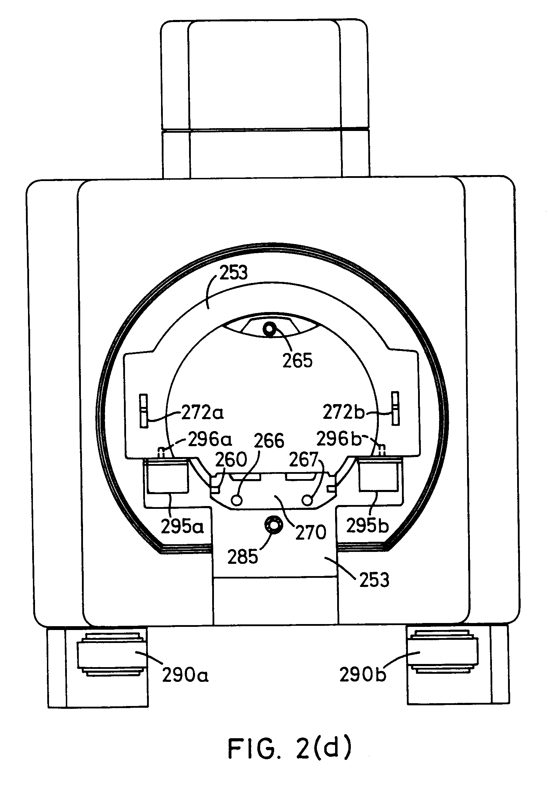

Referring first to FIGS. 1a, 1b, and 1c, a detailed illustration of a gradient transport cart 100 of the present invention is shown. The gradient transport cart 100 is utilized to transport multiple configurations of imaging gradient coils. The gradient transport cart 100 is essentially a "generic" transport cart in the sense that it provides a mechanism for allowing a variety of different gradient coils (e.g., head gradient coils or spine gradient coils) to be attached to the gradient transport cart 100, and therefore utilized by a magnetic resonance imaging (MRI) system 200, (see FIG. 2(a) - 2(d) discussed below). However, the design and configuration of the gradient transport cart 100 usually is specifically designed around the particular type of gradient coil currently being utilized by a technician operating the MRI system. It will be readily obvious to those skilled in the art to make the minor changes in the structure of the gradient transport cart 100 to incorporate a particular type of gradient coil. The preferred embodiment of the present invention was designed to house a head gradient coil.

Once the gradient coil is attached to the gradient transport cart 100, as described below, it is positioned and temporarily fastened within a MRI magnet. The gradient transport cart 100 allows removal of the gradient coil from the MRI system 200. The gradient transport cart 100 can then be stored in an appropriate location apart from the MRI system for future use. The gradient transport cart 100 is designed to occupy minimal floor space.

Referring now to FIG. 2a, a side view of the MRI system 200 which utilizes the gradient transport cart 100 is shown.

The MRI system 200 utilized by the present invention is of conventional design. Any present or future developed MRI system can be utilized with the present invention. One skilled in the art of MRI technology will readily understand from the description below the changes that must be made to the conventional MRI system in order to incorporate the gradient transport cart 100 of the present invention. Specifically, the MRI system of the present invention is shaped and configured to allow the gradient transport cart 100 of the present invention to be inserted into the MRI magnet bore 250. This is clearly a mechanical change to accomodate the gradient transport cart 100. The present invention does not contemplate the need to make any technological changes in the operational behavior of the MRI system 200. However, with that in mind, the MRI system 200 can potentially be configured with any combination of application specific gradient coils that would complement the variety of different application specific gradient coils located on the gradient transport cart 100.

Specifically, the MRI system includes a magnet casing 210 (magnet assembly structure) which holds the MRI magnet (the MRI magnet is not shown in the drawings), a structure 220 which supports a flat bed 225, and a step 230. The flat bed 225 is slidably mounted on the second housing 220 in order to facilitate moving the patient (not shown) in and out of the MRI magnet bore 250, as shown in FIG. 2b. FIG. 2b shows a front view (i.e., looking in from the flat bed 225) of the MRI system 200. The flat bed 225 has a handle 227 for manually sliding or rolling the flat bed 225 into the MRI system 200.

Referring again to FIGS 1(a) - 1(c), the gradient transport cart 100 includes a structural frame for supporting an application specific imaging gradient coil 137, described below. The structural frame includes a lower frame, a vertical frame, and a support brace 122. The lower frame includes a pair of axial members 112a and 112b, a first horizontal member 113 perpendicular to the axial members 112a and 112b, and a second horizontal member 110. The vertical frame, attached at a right angle to the first horizontal member 113, includes a pair of vertical members 114a and 114b and a third horizontal member 111 attached perpendicular to the pair of vertical members 114a and 114b. Finally, a support brace 122 is placed between the vertical frame and the lower frame. It is readily apparent that the front end does not have a support member. This enables the gradient transport cart to enter the MRI system and not interfere with the MRI magnet. A bumper 125, described in detail below, does run across the front end of the gradient transport cart 100. However, since the bumper 125 is lower than the lower frame, the gradient transport cart 100 still does not interfere with the MRI magnet.

The structural frame is but one way of providing a frame in accordance with the present invention for supporting the application specific gradient coil. One skilled in the art could readily design other suitable frames for supporting the gradient coil.

The structural frame is the mechanical interface for the attachment of a gradient collar 130 at the uppermost horizontal and vertical faces of the third horizontal member 111 via conventional mechanical fasteners. The gradient collar 130 is a multi-purpose mechanical mounting platform fabricated in the preferred embodiment of the present invention of vacuum cast aluminum. A primary function of the gradient collar 130 is a means for attaching a gradient tube 135 via a bolting flange on the gradient collar 130.

The gradient tube 135 houses an application specific imaging gradient coil 137. The gradient tube 135 in the preferred embodiment of the present invention is constructed of a graphite and/or fiberglass composite. The gradient coil 137 is attached to the inside of the gradient tube 135 and appropriately positioned within the gradient tube 135 in order to allow the gradient coil 137 and MRI magnet to be homogeneously aligned. In other words, as is well known in the art, it is essential that the MRI magnet and the gradient coil 137 currently being used are centered along their respective isocenters (i.e., homogeneous region). Each individual magnet and gradient coil 137 have their own respective "usable region" that can be used to produce an image. If the two 'usable regions' are not aligned properly, the MRI system 200 will not produce a viable image. Consequently, the present invention provides a mechanism for appropriately adjusting the alignment of the gradient tube 135 in order to match the MRI magnet and the gradient coil 137 properly. Specifically, a gradient coil calibration shim plate(s) 155 is used to adjust the horizontal depth of the gradient tube 135 within the magnet bore 250. This is done as follows. Initially, the gradient tube 135 is attached to the gradient collar 130 and inserted into the MRI magnet bore 250. The MRI system 200 is tested, and in this test it is determined whether or not the MRI magnet and the gradient coil 137 are properly aligned. If they are properly aligned, then the gradient tube 135 is permenantly fastened to the gradient collar 130, and the MRI system, in conjunction with the gradient transport cart 100, is ready for use. However, if they are not properly aligned, ten a gradient coil calibration shim plate 155 is placed (and fastened) between the gradient tube 135 and the gradient collar 130. This acts to move the gradient tube 135 horizontally with respect to the MRI magnet bore 250, causing the spacial relationship between the MRI magnet and the gradient coil 137 to change correspondingly. The above process can be repeated and additional shim plates 155 can be inserted, until the MRI magnet and the gradient coil 137 are properly aligned, causing the image produced by the MRI system 200 to be accurate.

Typically, the gradient transport cart 100 houses a head gradient coil 137. Head gradient coils are asymmetrically designed. Asymmetrically designed gradient coils have a unique torquing problem. Consequently, the gradient coil 137 with the aid of the gradient transport cart 100 must be securely fastened to the MRI system 200. The gradient collar 130 is designed to support the cantilevered imaging gradient coil mass with minimal deflection, thus allowing for accurate coil positioning. The gradient transport cart 100 is accurately aligned and mechanically locked into the magnet assembly frame 210 (i.e., the gradient tube 135 is locked within the magnet bore 250) via a three-point attachment mechanism. A pin 170 and a pair of lock-in latch mechanisms 150 form a three-point brace at the back external face 253 of the MRI system 200. Referring to FIG. 2(d) Pin 170 is inserted into an opening 285 and the two lock-in latches 150 are engaged by hooking with the latch receptacles 272a and 272b. The lock-in latches 150 are conventional mechanical latches.

The second part of the three-point attachment mechanism can be seen in FIG. 1(c). FIG. 1(c) shows a front view of the gradient tube 135 of the present invention. Pins 175, 176, and 177 are engaged with internal surface features of the magnet bore 250, namely pins 175, 176, and 177 are inserted into openings 265, 266, and 267, as shown in FIG. 2(d). Described above, is the preferred means of securing the gradient transport cart 100 to the MRI system 200. However, the present invention contemplates securing the cart 100 to the MRI system 200 with any present or future developed fastening device.

In addition to the three-point attachment mechanism, the present invention provides a secondary latching mechanism 295a and 296b. Incorporated into the design of the MRI system 200 are outlets for connecting a power source or a water source to the system. Secondary latches 295 cover the outlets and protect them from outside interference. When the outlets are in use the latches are lifted. If, for example, the power was connected through latch 295, it is necessary to safe guard the possibility that someone might try to remove the gradient transport cart 100 without disconnecting the power source. Consequently, the secondary latches 295 of the present invention, when lifted, engage with the gradient collar 130 via locks 296a and/or 296b. Thus, it becomes impossible to remove the gradient transport cart 100 without first disconnecting the power supply.

Referring to FIG. 1(a), integrated into the axial members 112a and 112b are two sets of independently rotatable transport wheels 115a and 115b. The rear set of wheels 115b are capable of being locked in any position via a "dead-man" braking mechanism. The "dead-man" braking mechanism is activated and deactivated by engaging a lever mounted within the bar handle release of the push bar 275. The release of the lever on the push bar 190 actuates the wheel lock system by gravity and torsional spring assisted displacement of a series of interconnected toggle linkages to a brake pad integrated with the rear wheel assemblies 115b. The actuation of the lever on the push bar 190 recreates the above events in reverse. In other words, actuating the lever unlocks the wheel brakes, thus aiding in eliminating "runaway train" potential.

As best shown in FIG. 1(a), installed in axial terminations of the lower frame are bumpers 125 fabricated in the preferred embodiment of the present invention of cast rubber. However, any suitable shock absorbing material can be used for bumber 125. The bumpers 125 provide a dual purpose: anticollision protection and guidance capabilities. It is desirable that the gradient coil not make physical contact with the external magnet casing 210 or internal walls of the MRI system. The gradient transport system 100 is designed to allow entry into the magnet bore 250 without allowing the gradient tube 35 to make contact with the magnet casing 210 or magnet bore 250.

Referring to FIG. 2d, a back view (without the gradient transport cart 100 in place) of the MRI system 200 is shown. The MRI system 200 is supplied with a pair of guide wheels 290a and 290b. The guide wheels 290 are designed to allow the lower frame bumpers 125 (FIG. 1(a)) to position the gradient transport cart 100 for entry into the MRI system 200. Thus, the guide wheels 290a and 290b extend outward from the MRI system 200 far enough to assure that the gradient tube 135 does not make physical contact with the magnet casing 210 or magnet bore interior.

The lower frame members are sheathed or covered.with sheet metal skins 160 to conceal construction welds and support angles while adding to the overall design motif and appearance.

In addition, the gradient collar 130 casting also integrates mechanical fastening points 139 for decorative fiberglass covers 140, a dead-man brake assembly 120, magnet lock-in latches 150, gradient coil calibration shim plate(s) 155, and any electrical interconnection necessary to operate the gradient coil. In addition to necessary electrical interconnections, the present invention contemplates providing connections for: a thermocoupler temperature monitor for monitoring the temperature in the gradient coil and ID tag assigned to every individual gradient coil, thus allowing a computer to readily ascertain the type of gradient coil presently being used.

Furthermore, it is contemplated that the present invention can be hooked up to a water source to provide an on board water cooling system.

Generally, the gradient transport cart 100 is easily maneuvered about within limited spaces, and brought to its entry point at the gradient end 253 of the magnet assembly 210. The technician (not shown) roughly physically positions and centers the gradient transport cart 100 with the magnet bore 250 (aided by the bumper mechanism 125 described above). He/She then begins to insert the gradient transport cart 100 slowly into the magnet bore 250.

Referring to FIG. 2(d), the interior of the magnet bore 250 has integrated guidance rollers 260 which assist in automatically physically aligning the gradient transport cart 100 with the magnets bore axis as the technician pushes the gradient transport cart 100 into the MRI system 200. The guidance rollers 216 are positioned to interface with the outer, vertical, sheathed faces of the gradient tube 135, and to assist in fine alignment of the gradient tube 135 with the magnet bore 250.

In addition, and referring to FIGS. 1a and 1c, the gradient tube 135 is equipped with a pair of support/guide wheel assemblies 165. The support/guide wheel assemblies 165 are affixed transverse to the longitudinal axis of the gradient tube 135. As the gradient transport cart 100 enters the magnet bore 250 under control of the technician, the support/guide wheel assemblies 165 engage a platform 270 integral with the inner surface of the magnet bore 250 along its longitudinal axis. The wheel assemblies allow the gradient transport cart 100 gracefully to enter the magnet bore 250, so as not to cause any physical damage.

FIG. 2c shows a back view of the MRI system 200 with the gradient transport cart 100 in place. Once the lock-in latches 150 have been engaged, the gradient transport cart fits neatly into the back of the MRI system 200, and there are no unnecessary intrusions into the space surrounding the MRI system 200. In addition, a fiberglass covering 280 is placed on the back of the gradient transport cart 100 to add to the overall design motif.

While the invention has been particularly shown and described with reference to preferred embodiments thereof, it will be understood by those skilled in the art that various changes in form and details may be made therein without departing from the spirit and scope of the invention.

## Claims

1. A gradient transport cart for transporting at least two configurations of imaging gradient coils, the gradient transport cart configured to operate within a magnetic resonance imaging (MRI) system, the gradient transport cart comprising:
(a) a main frame;
(b) a plurality of rotatable transport wheels connected to said frame so as to allow said main frame to move on a horizontal surface;
(c) a gradient collar connected to said frame;
(d) a gradient coil tube for housing one of the imaging gradient coil, the imaging gradient coil tube connected to said gradient collar; and
(e) attachment means for attaching said gradient coil tube to said gradient collar, whereby the gradient transport cart with the image gradient coil can be moved into and out of a magnet bore of the MRI device.

2. The gradient transport cart of claim 1, further comprising means for releasably attaching the gradient transport cart within the MRI system.

3. The gradient transport cart of claim 1 or 2, further comprising at least one gradient coil calibration shim plate, said shim plate being connected between said gradient collar and said gradient coil tube to adjust the physical relationship between the MRI device and the imaging gradient coil.

4. The gradient transport cart of claim 1, 2 or 3 further comprising braking means for locking at least one of said plurality of rotatable transport wheels so that the gradient transport cart does not move.

5. The gradient transport cart of any preceding claim, further comprising input means for allowing power and/or water and/or electrical connection to access the gradient transport cart.

6. The gradient transport cart of claim 5, wherein said input means further comprises security means for securing said gradient collar to the MRI system so that the gradient transport cart cannot be removed without disconnecting said power and/or water and/or electrical connection.

7. The gradient transport cart of claim 1, further comprising stabilizing means for stabilizing said gradient coil, wherein said stabilizing means comprises a plurality of pins that engage with the MRI magnet casing.

8. A system for providing magnetic resonance imagery (MRI), comprising:
(a) a MRI magnet; and
(b) a gradient transport cart, wherein said cart comprises,
(1) a frame;
(2) a plurality of rotatable transport wheels connected to said frame;
(3) a gradient collar connected to said frame;
(4) a gradient coil tube for housing a gradient coil, said gradient coil tube connected to said gradient collar; and
(5) attachment means for attaching said gradient coil tube to said gradient collar.
